# EUROPEAN PATENT APPLICATION

(11) **EP 4 495 609 A1**
(43) Date of publication of application: **22.01.2025**
(21) Application number: 24181784.0
(22) Date of filing: 12.06.2024
(51) Int. Cl.: G01R 31/26

(54) **A STRESS CALIBRATION METHOD, CORRESPONDING ELECTRONIC DEVICE AND VEHICLE**

(30) Priority: 18.07.2023 IT 202300015036
(71) Applicant: STMicroelectronics International N.V., 1228 Plan-les-Ouates, Geneva (CH)
(72) Inventor: MORETTI, Emanuele, I-20152 Milano (IT); FOPPIANI, Mauro, I-20147 Milano (IT)
(74) Representative: Buzzi, Notaro & Antonielli d'Oulx S.p.A.

(57) **Abstract**

A method, comprising: providing a set of electronic switches (Q1, ..., Qn), wherein each electronic switch in the set of electronic switches (Q1, ..., Qn) comprises a respective control node (G1, ..., Gn); coupling one end of coupling channels of a set of coupling channels (101,...,10n) to a common test node (TEST_PAD) and the other ends of coupling channels of a set of coupling channels (101,...,10n) to respective control nodes (G1, ..., Gn) of electronic switches in the set of electronic switches (Q1, ..., Qn); based on an enable calibration signal (TS) having a first logic value, coupling (161,...,16n) a first input node of comparator circuits of a set of comparator circuits (141,...,14n) to the control node (G1, ..., Gn) of respective electronic switches in the set of electronic switches (141,...,14n) ; applying the test voltage to the common node (TEST_PAD) ; performing a set of comparisons (141,14n) of the set of control voltages sensed at the control nodes (G1,...,Gn) of the electronic switches in the set of electronic switches (Q1,...,Qn) and the threshold reference voltage (V_REF), producing a set of comparison signals (VGS_COMP1, ...,VGS_COMP2) having a logic value based on the results of the comparisons; interrupting performing the set of comparisons (141,...,14n) and increasing the test voltage applied at the common test node (TEST_PAD) in response to each and every comparison signal in the set of comparison signals having the first logic value, and providing the value reached by the test voltage applied at the common test node (TEST_PAD) as a calibrated stress test voltage value to a user circuit.

## Description

### Technical field

The description relates to methods and systems for testing circuits, such as low side driver circuits comprising metal-oxide-semiconductor field-effect (briefly, MOS-FET) transistors, for instance.

One or more embodiments may be applied in integrated circuits (briefly, ICs) comprising power MOSFETs, such as an engine control unit (briefly, ECU) of an automotive engine management system (briefly, EMS), for instance.

### Background

An ECU or engine control module (briefly, ECM) is an electronic control unit configured to process signals from sensors and configured to control a series of actuators equipped on an (e.g., internal combustion or electric) engine based on signals received from sensors equipped on the engine.

An ECU may comprise electric loads, such as sensors, LEDs, and other loads such as resistive and/or inductive load circuits.

The power transistors employed in half-bridge arrangements may be subject to reliability tests during their manufacturing.

For instance, a pulsed-gate stress test (briefly, gatestress) approach comprises a method to identify defects that, if the test is not performed and / or is not effective, may emerge during IC usage, even after some time. For instance, the gatestress method is performed at wafer level for quality checks. The application of the gatestress may comprise a test circuit that uses dedicated pads coupled to internal gates of the power MOSFETs under test.

The gatestress test comprises, for instance:
measuring a first gate leakage current before applying a voltage stress to the transistor;
during a test time interval (e.g., hundreds of milliseconds, 1 millsecond = 1 ms = 10⁻³ s), applying a stress voltage equal or higher absolute maximum rating, AMR parameters, that is a maximum voltage that an electronic component can sustain without damage among its (e.g., gate-source) terminals;
at lapse of the test time interval, measuring a second gate leakage current, and
performing a comparison of the first and the second gate leakage currents.

In case the comparison yields that the second current is greater than the first, this may indicate the presence of a latent gate oxide defect in the transistor, not visible during normal operation at room temperature, activated in response to the stress voltage application, for instance. Therefore, the transistor under test may be labeled as faulty.

Devices comprising integrated power MOSFETs can further comprise gate-source voltage comparators configured to produce a first (e.g., "high" or "1") state in response to the voltage across gate and source terminals of the power transistor is above the threshold during the turn on phase. The output of this comparator can be used for different purposes in functional mode (such as overload diagnosis structures, management of dead times, etc.)

During the gatestress procedure, the current sinked by low side driver circuitry (in particular in multiple - channels devices) can be appreciable (e.g., in the range of 10 milliAmpere, with 1 milliAmpere = 1mA = 10⁻³ A).

This may lead to an equally appreciable voltage drop on internal metal connections, for instance between the pad used to force the stress voltage with EWS probe (tests at wafer level) and the effective gate-to-source voltage applied during stress.

Such a scenario can be difficult to detect and it may lead to a lack of effective stress on all or some drivers. Also at the simulation level, it can be hard to understand the phenomenon without considering metal connections and parasitic components.

Any discrepancy between simulation results and automatic test equipment (briefly, ATE) level measurements can indicate an appreciable risk of the presence of underperforming parts during pre-production steps (e.g., due to failures such as "burn in" test or field returns).

### Object and summary

An object of one or more embodiments is to contribute in mitigating the aforementioned issues.

For instance, the proposed solution can introduce a better control of the stress voltage applied during a gatestress procedure.

According to one or more embodiments, that object can be achieved via a method having the features set forth in the claims that follow.

One or more embodiments may relate to a corresponding test circuit.

One or more embodiments may relate to a corresponding vehicle.

The claims are an integral part of the technical teaching provided herein with reference to the embodiments.

One or more embodiments comprise comparing the stress voltage applied during testing with an internal threshold.

One or more embodiments may lead to an improved control of the gatestress procedure.

One or more embodiments counter the risk of having power MOSFET gates poorly stressed during the test phase.

One or more embodiments facilitate reducing the probability to have burn-in failures and/or field returns related to gate oxide defectiveness.

One or more embodiments facilitate to have quick feedback from a test device indicative of the effective gate voltage applied to individual power (e.g., MOSFET) transistors under test.

### Brief description of the several views of the drawings

One or more embodiments will now be described, by way of non-limiting example only, with reference to the annexed Figures, wherein:
- Figure 1 is a diagram exemplary of a method as per the present disclosure,
- Figure 2 is a diagram exemplary of a circuit as per the present disclosure,
- Figure 3 is a diagram exemplary of a test device as per the present disclosure,
- Figure 4 is a diagram exemplary of a vehicle as per the present disclosure.

Corresponding numerals and symbols in the different figures generally refer to corresponding parts unless otherwise indicated.

The figures are drawn to clearly illustrate the relevant aspects of the embodiments and are not necessarily drawn to scale. The edges of features drawn in the figures do not necessarily indicate the termination of the extent of the feature.

### Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The references used herein are provided merely for convenience and hence do not define the extent of protection or the scope of the embodiments.

For the sake of simplicity, in the following detailed description a same reference symbol may be used to designate both a node/line in a circuit and a signal which may occur at that node or line.

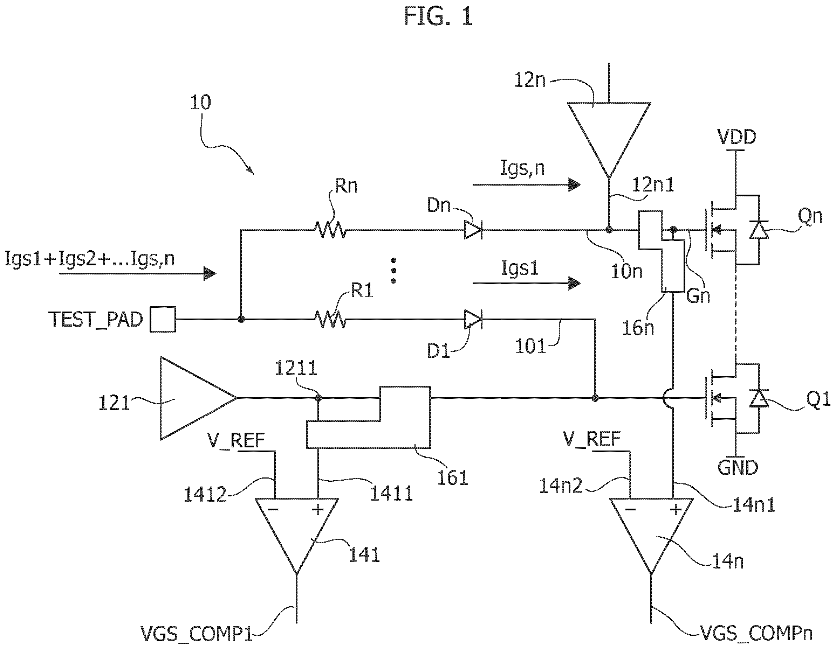

As exemplified in Figure 1, a circuit 10 for performing a stress test at a control terminal GQ (e.g., gate terminal) of a (e.g., MOSFET) transistor Q comprises:
a test input node TEST_PAD configured to be coupled to an electrical source configured to generate a stress voltage to perform a test of the circuit 10, e.g., providing a total current equal to a sum Igs1+Igs2+...+Igsn electrical currents Igs1, ..., Igsn flowing in a set of test channels 101,...,10n for electronic switches Q1,...,Qn, as discussed in the following;
a set of electronic switches Q1,...,Qn having respective control nodes G1,...,Gn configured to be coupled to the test input node TEST_PAD to be put under test;
a set of test channels 101,...,10n coupling the test input node TEST_PAD to the control nodes G1,...,Gn of respective electronic switches in the set of electronic switches Q1,...,Qn; for instance, each test channel in the set of test channels 101,...,10n comprises a series arrangement of a resistive element and a diode belonging to respective sets of resistive elements R1,...,Rn and diodes D1,...,Dn;
a set of driver circuits 121,...,12n, each driver circuit in the set of driver circuits 121,...,12n configured to provide, at a respective driver output node of a set of driver output nodes 1211,...,121n, a respective control signal to the respective control terminal G1,...,Gn of the respective electronic switch in the set of electronic switches Q1,...,Qn;
a set of (e.g., voltage) comparator circuits 141,...,14n coupled to a reference node V_REF to receive a reference (e.g., voltage) value V_REF therefrom and coupled to the set of electronic switches Q1,...,Qn, each comparator circuit in the set of comparator circuits 141,...,14n comprising a respective first input node 1411....,14n1 coupled to the respective output node 1211,...,12n1 of the respective driver circuit in the set of driver circuits 121,...,12n and a second input node 1412,...,14n2 coupled to the reference node V_REF,
a set of coupling circuit blocks 161,...,16n interposed the first input nodes 1411, ..., 14n1 of the comparator circuits in the set of comparator circuits 141,...,14n, and the control nodes G1,...,Gn of the electronic switches in the set of electronic switches Q1,...,Qn; the coupling circuit blocks in the set of coupling circuit blocks 161,...,16n comprises circuitry configured to selectively couple the control nodes G1,...,Gn of electronic switches in the set of electronic switches Q1,...,Qn to the comparator circuits in the set of comparator circuits 141,...,14n.

For instance, each comparator circuit in the set of comparator circuits 141,...,14n is configured to be coupled, via the coupling circuit blocks in the set of coupling circuit blocks 161,...,16n, to each respective control node of the electronic switches perform a comparison among the reference value V_REF and (e.g., voltage) signals sensed at the control nodes of the respective devices under test Q1,...,Qn, the comparator circuits 141,...,14n further configured to produce respective comparison signals VGS_COMP1,...,VGS_COMPn as a result.

As exemplified in Figure 1, the reference value V_REF is greater than a minimum stress voltage (e.g., V_REF>V_STRESS_MIN) that the circuit 10 is designed to deliver to the devices under test in the set of electronic switches Q1,...,Qn.

As exemplified herein, each comparator in the set of comparators is configured to detect, in response to the stress test voltage V_STRESS_MIN being applied at the test input node TEST_PAD, whether the actual signal sensed at the respective control node (e.g., G1) of the respective device under test (e.g., Q1) in the set of electronic switches Q1,...,Qn exceeds or fails to exceed (in other words, reaches or fails to reach) the reference voltage value V_REF.

For instance, in case the comparison yields that the sensed signal fails to exceed the reference value V_REF, the application of the stress test voltage V_TEST_MIN is repeated for the i-th switch (e.g., first switch Q) in the set of electronic switches Q1,...,Qn.

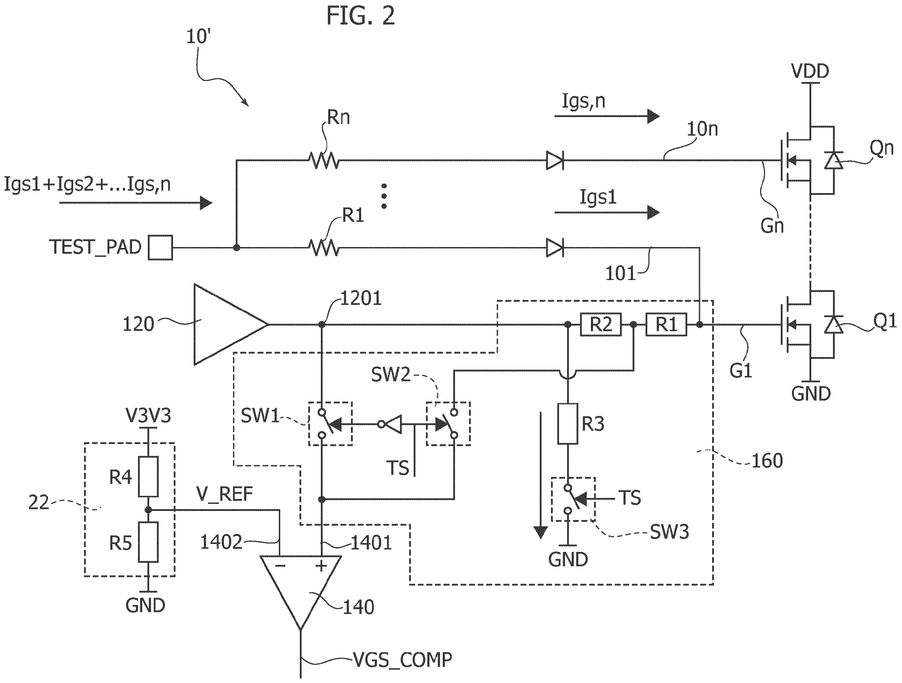

Figures 1 shows an alternative circuit 10' where a single comparator 140 is used for an electronic switch (e.g., the first electronic switch Q1) in the set of electronic switches Q1,...,Qn. Such an example is purely exemplary and in no way limiting, being otherwise understood that the implementation shown in Figure 2 may be combined with that of Figure 1 with the blocks shown in Figure 2 for a channel being repeated for a subset or for all channels of electronic switches under test.

As exemplified in Figure 2, the circuit 10' configured to facilitate applying stress voltage at the control terminal GQ of at least one transistor(s) Q1 under test comprises:
a driver circuit 120 configured to provide, at a respective driver output node 1201, a respective control signal to the respective control terminal G1 of the first electronic switch Q1;
a comparator circuit 140 comprising a first input node 1401 coupled to the output node 1201 of the driver circuit 120 and a second input node 1402 coupled to the reference node V_REF, the comparator circuit 140 configured to produce a comparison signal VGS_COMP based on the comparison of signals received at input nodes 1401, 1402;
a coupling circuit 160 interposed the first input node 1401 of the comparator circuit 140 and the control node G1 of the first electronic switch Q1, the coupling circuit 160 comprising circuitry configured to selectively couple the control node G1 of first electronic switch Q1 to the comparator circuit 140;
a supply voltage node V3V3 configured to provide a supply voltage level, e.g., 2.7 Volt;
a voltage threshold generator circuit block 22 comprising a (e.g., resistive) voltage divider R4, R5 interposed between the supply voltage V3V3 and ground GND, the voltage threshold source 22 coupled to the second input node 1402 of the voltage comparator 140 and to provide the voltage threshold level V_REF thereto.

As exemplified in Figure 2, the coupling circuit block 160 comprises:
a first switch SW1 interposed between the output node 1201 of the driver circuit 120 and the first input node 1401 of the voltage comparator 140;
a second switch SW2 interposed between the first input node 1401 of the comparator 140 and a set of resistive elements R1, R2 comprising a first resistive element R1 in series with a second resistive element R2, the set of resistive elements R1, R2 arranged between the control node G1 of the first electronic switch Q1 and the output node 1201 of the driver circuit 120;
a third switch SW3 interposed between a third resistive element R3 having one end coupled to the set of resistive elements R1, R2, (specifically, intermediate the first and second resistive elements) and ground GND,
an inverter circuit 1601 coupled to the first switch SW1 and configured to receive a calibration enable signal TS to operate the switch SW1.

As exemplified in Figure 2, the first SW1, second SW2 and third SW3 switches are each configured to switch between a first ("closed" or "ON") state in which they are made conductive and a second ("open" or "OFF") state in which they are made non-conductive based on the calibration enable signal TS. Specifically, among the first SW1 and the second switch SW2, only one may be made conductive at the same time thanks to the presence of the inverter circuit 1601.

In one or more embodiments, using a fraction of the supply voltage V3V3 as a reference voltage facilitates calibrating the procedure to define the minimum stress voltage level.

A method of calibrating a gatestress procedure comprises, for instance:
asserting the calibration enable signal TS with a first logic value (e.g., "1" or "true"), switching the first switch SW1 in the second OFF state while switching the second SW2 and third SW3 switches in the first ON state as a result;
applying a calibration voltage level (e.g., multiple of a step about 100 mV) to the test pad node coupled to the first test channel 101 coupled to the first electronic switch Q1;
after application of the stress test voltage, receiving at the first input node 1401 of the comparator 140 a control voltage sensed at the control node G1 of the first electronic switch Q1, via the resistive divider formed by resistive elements R1, R2, R3;
providing a threshold reference voltage V_REF at the second input node 1402 of the comparator circuit 140, and
performing a comparison of the sensed control voltage and the threshold reference voltage V_REF, producing a comparison signal VGS_COMP as a result having a first logic value (e.g., "1" or "high") in response to the sensed control voltage exceeding the threshold reference voltage V_REF and a second logic value (e.g., "0" or "low") otherwise;
in response to the comparison signal VGS_COMP having the second logic value, increasing the calibration voltage level (e.g., by a step about 100 mV) and repeating the operations of the method discussed in the foregoing until the comparison signal VGS_COMP has reached the first logic value, providing an indication of an effective stress voltage level V_STRESS_MIN equal to the calibration voltage that produces the first logic value of the comparison signal VGS_COMP, for instance providing it to user circuitry such as an engineering work station (EWS);
at the end of the calibration procedure, that is after obtaining the value of the effective stress voltage level V_STRESS_MIN, asserting the calibration enable signal TS to the second logic level (e.g., "0" or "low") in order to couple the first input node 1401 of the comparator circuit 140 to the output node 1201 of the driver circuit 12.

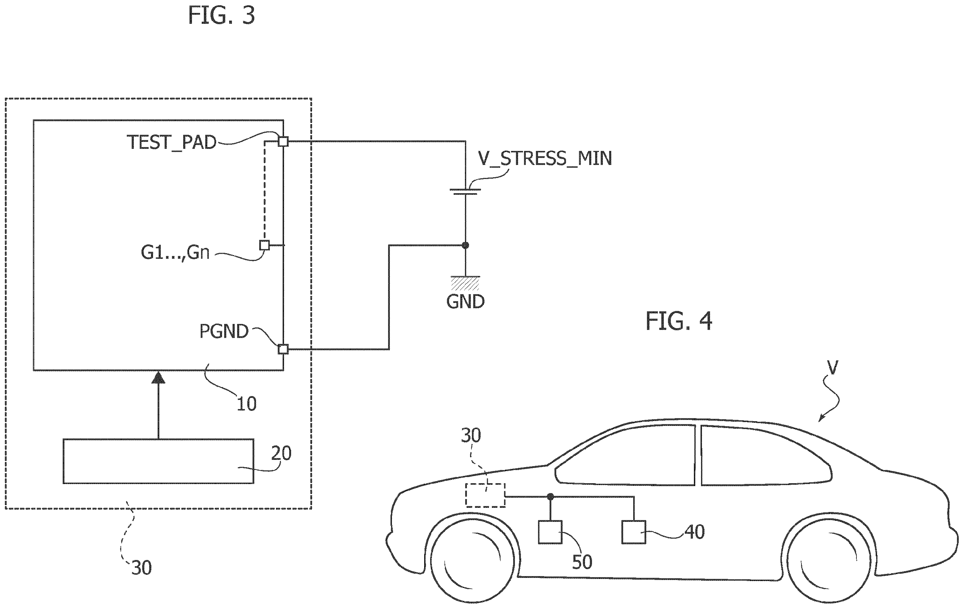

As exemplified in Figure 3, the resistive elements R1, R2, R3 of the coupling circuitry 160 and the resistive elements R4, R5 in the threshold voltage generator circuit block 22 may have resistance values linked by some relation therebetween.

For instance:
the first R1 and second resistive elements R2 may have a resistance value equal to the resistance value of a fourth resistive element R4 in the threshold voltage generator circuit block 22, and
the third resistive element R3 may have a resistance value equal to the resistance value of a fifth resistive element R5 in series with the fourth resistive element in the threshold voltage generator circuit block 22.

As exemplified herein, the resistive elements R1, R2, R3 of the coupling circuitry 160 are designed so as to protect the CMOS driver from excessive stress voltages during the test phase. For instance, a maximum voltage applicable to the driver may be about 3.6 Volts for a 4.6 Volts of AMR while during the gatestress procedure the voltages may reach values about 6 Volts.

Thanks to the use of the coupling circuit 160, it is possible to exploit a reference voltage VREF which is a fraction of the internal supply voltage V3V (e.g., 3.3 Volts), in order to counter the risk of having to use higher values (e.g., 6 Volts).

As exemplified in Figure 3, an electronic device 30 (e.g., to be used in a test production phase) comprises an internal power supply source 20 configured to be coupled to a voltage generator to apply the stress voltage V_STRESS_MIN (obtained as a result of the calibration procedure) thereto via the TEST_PAD node of the circuit 10, 10' to verify its state.

Figure 4 is exemplary of one or more embodiments of a (e.g., wheeled and/or electrically powered) vehicle V comprising a set of electronic control units 40, 50 coupled to a set of devices 60 according to the present disclosure, for instance equipped with a set of power MOSFETs that have been tested according to a method as per the present disclosure.

As exemplified in Figure 3, a device 60 comprises:
a circuit 10, 10' as per the present disclosure,
an electrical supply source V_STRESS_MIN configured to provide a stress voltage, and

As illustrated herein, the electronic device 30 may be equipped onboard an automotive vehicle V, preferably an electrically powered automotive vehicle.

One or more embodiments may thus provide improved robustness against malfunctioning of the power MOSFETs exploited by ECUs 40, 50 on-board the vehicle. This may be advantageous to fulfill safety requirements in the automotive field.

For instance, an energy management system, EMS, unit 40 configured to manage energy of the vehicle V is coupled to the device 30 as per the present disclosure.

A method as exemplified herein comprises:
providing a set of electronic switches Q1,...,Qn having a current line therethrough between a supply node VDD and ground GND, wherein each electronic switch in the set of electronic switches comprises a respective control node G1,...,Gn to receive a calibrated stress test voltage V_STRESS_MIN;
coupling one end of coupling channels of a set of coupling channels 101,...,10n to a common test node TEST_PAD and the other ends of coupling channels of a set of coupling channels to respective control nodes of electronic switches in the set of electronic switches, wherein the set of coupling channels is configured to propagate application of a test voltage V_STRESS_MIN from the common test node to respective control nodes of the electronic switches in the set of electronic switches;
based on an enable calibration signal TS having a first logic value, coupling 160; 161,...,16n a first input node of comparator circuits of a set of comparator circuits 140; 141,...,14n to the control node of respective electronic switches in the set of electronic switches;
providing a threshold voltage level V_REF to a second input node of comparator circuits of the set of comparator circuits;
applying the test voltage to the common node TEST_PAD;
sensing R1, R2, R3 at the first input nodes of the set of comparators a set of control voltages comprising control voltages sensed at the control nodes of the electronic switches in the set of electronic switches;
performing a set of comparisons 140; 141,...,14n of the set of sensed control voltages and the threshold reference voltage, producing a set of comparison signals VGS_COMP; VGS_COMP1,...,VGS_COMP2 having a first logic value in response to sensed control voltages in the set of sensed control voltages exceeding the threshold reference voltage and a second logic value in response to the sensed control voltages in the set of sensed control voltages failing to exceed the threshold reference voltage;
in response to at least one comparison signal VGS_COMP in the set of comparison signals VGS_COMP1,...,VGS_COMP2 having the second logic value, increasing the test voltage applied at the common test node;
interrupting performing the set of comparisons and increasing the test voltage applied at the common test node in response to each and every comparison signal in the set of comparison signals having the first logic value, and
providing the value reached by the test voltage applied at the common test node as a calibrated stress test voltage value to a user circuit.

For instance:
in response to the calibration enable signal having the first logic value, coupling SW2 at least one resistive voltage divider R1, R2, R3 to control nodes of the electronic switches in the set of control switches, sensing the sensed control voltages via the at least one resistive voltage divider as a result;
coupling a supply voltage level V3V3 at one end of a series arrangement of resistive elements referred to ground R4, R5, providing the threshold reference voltage at a node intermediate the series arrangement as a result,
wherein resistive elements in the resistive voltage divider have resistance values based on resistance values of resistive elements in the series arrangement of resistive elements coupled to the supply voltage level.

As exemplified herein, the set of electronic switches is coupled to a set of driving circuits 120; 121,...,12n and wherein control nodes of electronic switches in the set of electronic switches are coupled to an output node 1201; 1211,...,121n of a respective driving circuit in the set of driving circuits, each control node configured to receive a control signal from a respective driving circuit, wherein the current flow line is configured to be made at least partially conductive or non-conductive based on a logic value of said control signal.

As exemplified herein, electronic switches in the set of electronic switches comprise transistors, preferably MOSFET transistors.

For instance, increasing the test voltage comprises step-wise increasing the test voltage starting from a minimum voltage level to a maximum voltage level, preferably by a step about 100 mV.

A test circuit 10, 10', 30 as exemplified in any one of Figures 1 to 3 comprises:
a set of electronic switches Q1,...,Qn configured to have a current line therethrough between a first node VDD and ground GND, wherein each electronic switch in the set of electronic switches comprises a respective control node to receive a calibrated stress test voltage V_STRESS_MIN;
a set of coupling channels 101,...,10n having one end coupled to a common test node TEST_PAD and the other ends coupled to respective control nodes G1,...,Gn of electronic switches in the set of electronic switches, wherein the set of coupling channels 101,...,10n are configured to propagate application of a test voltage V_STRESS _MIN from the common test node to respective control nodes of the electronic switches in the set of electronic switches;
a threshold voltage node configured to receive a threshold voltage V_REF;
a stress voltage supply source configured to apply a calibrated stress test voltage to the common node;
a set of comparator circuits 140; 141,...,14n comprising comparator circuits having a first input node coupled, via sensing circuitry R1, R2, R3, to the control node of respective electronic switches in the set of electronic switches and having second nodes coupled to the threshold voltage node,
wherein the sensing circuitry is configured to sense a set of control voltages at the control nodes of the electronic switches in the set of electronic switches,
wherein the set of comparator circuits is configured to perform a set of comparisons of the set of sensed control voltages and the threshold reference voltage and to produce a set of comparison signals having a first logic value in response to sensed control voltages in the set of sensed control voltages exceeding the threshold reference voltage and a second logic value in response to the sensed control voltages in the set of sensed control voltages failing to exceed the threshold reference voltage, the set of comparators configured to provide the set of comparison signals VGS_COMP; VGS_COMP1,...,VGS_COMP2 to a user circuit.

As exemplified in any one of Figures 1 to 3, the sensing circuitry comprises at least one resistive voltage divider R1, R2, R3 referred to ground coupled to control nodes of the electronic switches in the set of control switches, sensing the sensed control voltages via the at least one resistive voltage divider as a result, and
wherein the threshold voltage node is coupled to a supply voltage level V3V3 at one end of a series arrangement of resistive elements referred to ground R4, R5, providing the threshold reference voltage V_REF at a node intermediate the series arrangement as a result,
wherein resistive elements in the resistive voltage divider have resistance values based on resistance values of resistive elements in the series arrangement of resistive elements.

As exemplified in any one of Figures 1 to 3, the set of electronic switches is coupled to a set of driving circuits 120; 121,...,12n and wherein control nodes of electronic switches in the set of electronic switches are coupled to an output node 1201; 1211,...,121n of a respective driving circuit in the set of driving circuits, each control node configured to receive a control signal from a respective driving circuit, wherein the current flow line is configured to be made conductive or non-conductive based on a logic value of said control signal.

As exemplified in any one of Figures 1 to 3, electronic switches in the set of electronic switches comprise transistors, preferably MOSFET transistors.

As exemplified in Figure 4, a vehicle (e.g., a battery-powered wheeled vehicle) equipped with the test circuit 10, 10', 30 according to any one of Figures 1 to 3.

It will be otherwise understood that the various individual implementing options exemplified throughout the figures accompanying this description are not necessarily intended to be adopted in the same combinations exemplified in the figures. One or more embodiments may thus adopt these (otherwise non-mandatory) options individually and/or in different combinations with respect to the combination exemplified in the accompanying figures.

Without prejudice to the underlying principles, the details and embodiments may vary, even significantly, with respect to what has been described by way of example only, without departing from the extent of protection. The extent of protection is defined by the annexed claims.

## Claims

1. A method, comprising:
providing a set of electronic switches (Q1,...,Qn) having a current line therethrough between a supply node (VDD) and ground (GND), wherein each electronic switch in the set of electronic switches (Q1,...,Qn) comprises a respective control node (G1,...,Gn) to receive a stress test voltage (V_STRESS_MIN);
coupling one end of coupling channels of a set of coupling channels (101,...,10n) to a common test node (TEST_PAD) and the other ends of coupling channels of a set of coupling channels (101,...,10n) to respective control nodes (G1,...,Gn) of electronic switches in the set of electronic switches (Q1,...,Qn), wherein the set of coupling channels (101,...,10n) is configured to propagate application of a test voltage (V_STRESS_MIN) from the common test node (TEST_PAD) to respective control nodes (G1,...,Gn) of the electronic switches in the set of electronic switches (Q1,...Qn);
based on an enable calibration signal (TS) having a first logic value, coupling (160; 161,...,16n) a first input node of comparator circuits of a set of comparator circuits (140; 141,...,14n) to the control node (G1,...,Gn) of respective electronic switches in the set of electronic switches (140; 141,...,14n) ;
providing a threshold voltage level (V_REF) to a second input node of comparator circuits of the set of comparator circuits (140; 141,...,14n) ;
applying the test voltage to the common node (TEST_PAD);
sensing (R1, R2, R3) at the first input nodes (1401; 1411,...,14n1) of the set of comparators (140; 141,...,14n) a set of control voltages comprising control voltages sensed at the control nodes (G1,...,Gn) of the electronic switches in the set of electronic switches (Q1,...,Qn);
performing a set of comparisons (140; 141,...,14n) of the set of sensed control voltages and the threshold reference voltage (V_REF), producing a set of comparison signals (VGS_COMP; VGS_COMP1,VGS_COMP2) having a first logic value in response to sensed control voltages in the set of sensed control voltages exceeding the threshold reference voltage (V_REF) and a second logic value in response to the sensed control voltages in the set of sensed control voltages failing to exceed the threshold reference voltage (V_REF);
in response to at least one comparison signal (VGS_COMP) in the set of comparison signals (VGS_COMP; VGS _COMP1,...,VGS_COMP2) having the second logic value, increasing the test voltage applied at the common test node (TEST_PAD);
interrupting performing the set of comparisons (140; 141,...,14n) and increasing the test voltage applied at the common test node (TEST_PAD) in response to each and every comparison signal in the set of comparison signals having the first logic value, and
providing the value reached by the test voltage applied at the common test node (TEST_PAD) as a calibrated stress test voltage value (V_STRESS_MIN) to a user circuit.

2. The method of claim 1, comprising:
in response to the calibration enable signal (TS) having the first logic value, coupling (SW2) at least one resistive voltage divider (R1, R2, R3) to control nodes (G1,...,Gn) of the electronic switches in the set of control switches (Q1,...,Qn), sensing the sensed control voltages via the at least one resistive voltage divider (R1, R2, R3) as a result;
coupling a supply voltage level (V3V3) at one end of a series arrangement of resistive elements referred to ground (R4, R5), providing the threshold reference voltage (V_REF) at a node intermediate the series arrangement as a result,
wherein resistive elements in the resistive voltage divider (R1, R2, R3) have resistance values based on resistance values of resistive elements in the series arrangement of resistive elements (R4, R5) coupled to the supply voltage level (V3V3).

3. The method of claim 1 or claim 2, wherein the set of electronic switches (Q1,...,Qn) is coupled to a set of driving circuits (120; 121,...,12n) and wherein control nodes (G1,...,Gn) of electronic switches in the set of electronic switches (Q1,...,Qn) are coupled to an output node (1201; 1211,...,121n) of a respective driving circuit in the set of driving circuits (120; 121,...,12n), each control node (G1,...,Gn) configured to receive a control signal from a respective driving circuit, wherein the current flow line is configured to be made at least partially conductive or non-conductive based on a logic value of said control signal.

4. The method of any one of the previous claims, wherein electronic switches in the set of electronic switches (Q1,...,Qn) comprise transistors, preferably MOSFET transistors.

5. The method of claim 1, wherein increasing the test voltage comprises step-wise increasing the test voltage starting from a minimum voltage level to a maximum voltage level, preferably by a step about 100 mV.

6. A test circuit (10, 10'), comprising:
a set of electronic switches (Q1,...,Qn) configured to have a current line therethrough between a first node (VDD) and ground (GND), wherein each electronic switch in the set of electronic switches (Q1,...,Qn) comprises a respective control node (G1,...,Gn) to receive a calibrated stress test voltage (V_STRESS_MIN);
a set of coupling channels (101,...,10n) having one end coupled to a common test node (TEST_PAD) and the other ends coupled to respective control nodes (G1,...,Gn) of electronic switches in the set of electronic switches (Q1,...,Qn), wherein the set of coupling channels (101,...,10n) are configured to propagate application of a test voltage (V_STRESS_MIN) from the common test node (TEST_PAD) to respective control nodes (G1,...,Gn) of the electronic switches in the set of electronic switches (Q1,...,Qn);
a threshold voltage node configured to receive a threshold voltage (V_REF);
a stress voltage supply source (V_STRESS_MIN) configured to apply a calibrated stress test voltage (V_STRESS_MIN) to the common node (TEST_PAD);
a set of comparator circuits (140; 141,...,14n) comprising comparator circuits having a first input node coupled, via sensing circuitry (R1, R2, R3), to the control node (G1,...,Gn) of respective electronic switches in the set of electronic switches (140; 141,...,14n) and having second nodes coupled to the threshold voltage node (V_REF),
wherein the sensing circuitry (160; 161,...,16n) is configured to sense a set of control voltages at the control nodes (G1,...,Gn) of the electronic switches in the set of electronic switches (Q1,...,Qn),
wherein the set of comparator circuits (140; 141,...,14n) is configured to perform a set of comparisons of the set of sensed control voltages and the threshold reference voltage (V_REF) and to produce a set of comparison signals (VGS_COMP; VGS_COMP1,...,VGS_COMP2) having a first logic value in response to sensed control voltages in the set of sensed control voltages exceeding the threshold reference voltage (V_REF) and a second logic value in response to the sensed control voltages in the set of sensed control voltages failing to exceed the threshold reference voltage (V_REF), the set of comparators (140; 141,...,14n) configured to provide the set of comparison signals (VGS_COMP; VGS_COMP1,...,VGS_COMP2) to a user circuit.

7. The test circuit (10, 10') claim 6, wherein the sensing circuitry (160; 161, ...,16n) comprises at least one resistive voltage divider (R1, R2, R3) referred to ground coupled to control nodes (G1,...,Gn) of the electronic switches in the set of control switches (Q1,...,Qn), sensing the sensed control voltages via the at least one resistive voltage divider (R1, R2, R3) as a result, and
wherein the threshold voltage node is coupled to a supply voltage level (V3V3) at one end of a series arrangement of resistive elements referred to ground (R4, R5), providing the threshold reference voltage (V_REF) at a node intermediate the series arrangement as a result,
wherein resistive elements in the resistive voltage divider (R1, R2, R3) have resistance values based on resistance values of resistive elements in the series arrangement of resistive elements (R4, R5).

8. The test device of claim 6 or 7, wherein the set of electronic switches (Q1,...,Qn) is coupled to a set of driving circuits (120; 121,...,12n) and wherein control nodes (G1,...,Gn) of electronic switches in the set of electronic switches (Q1,...,Qn) are coupled to an output node (1201; 1211,...,121n) of a respective driving circuit in the set of driving circuits (120; 121,...,12n), each control node (G1,...,Gn) configured to receive a control signal from a respective driving circuit, wherein the current flow line is configured to be made conductive or non-conductive based on a logic value of said control signal.

9. The test circuit of any one of the previous claims, wherein electronic switches in the set of electronic switches (Q1,...,Qn) comprise transistors, preferably MOSFET transistors.

10. A vehicle equipped with the test circuit (10, 10', 30) according to any one of claims 6 to 9, preferably a battery-powered wheeled vehicle.
